# EUROPEAN PATENT APPLICATION

(11) **EP 4 712 343 A1**
(43) Date of publication of application: **18.03.2026**
(21) Application number: 23941594.6
(22) Date of filing: 15.06.2023
(51) Int. Cl.: H03F 3/217, H03F 1/02, H03K 19/0175

(54) **COMPLEMENTARY POWER SUPPLY MODULATOR**

(71) Applicant: MITSUBISHI ELECTRIC CORPORATION, Chiyoda-ku Tokyo 100-8310 (JP)
(72) Inventor: KUDARA, Ken, Tokyo 100-8310 (JP); KOMATSUZAKI, Yuji, Tokyo 100-8310 (JP)
(74) Representative: Pfenning, Meinig & Partner mbB
(86) International application number: PCT/JP2023/022173
(87) International publication number: WO 2024/257290

(57) **Abstract**

A complementary power supply modulator includes a high-voltage-side switching element (10) and a low-voltage-side switching element (20) that are connected in series between a first power supply potential node V₁ and a ground potential node, the high-voltage-side switching element (10) includes a first P-type transistor (11), the low-voltage-side switching element (20) includes a first N-type transistor (21), and the complementary power supply modulator includes a first combiner (30) that applies, to the gate electrode of the first P-type transistor (11), a PWM signal obtained by combining a PWM signal and a second voltage V₂ applied to a second power supply potential node V₂.

## Description

### TECHNICAL FIELD

The present disclosure relates to a complementary power supply modulator including complementary switching elements connected in series between a power supply potential node and a ground potential node.

### BACKGROUND ART

An applied bias voltage of power-supply-modulation amplifiers needs to be modulated depending on the voltage level of a high-frequency input signal which is a Pulse Width Modulation (PWM) signal.

Typically, the amplitude of the bias voltage of such a power-supply-modulation amplifier is twice as large as or more than twice as large as the voltage amplitude of a PWM signal.

It has been considered to use a P-type MOS transistor on the high-voltage side of a power-supply-modulation amplifier.

For example, it is considered to apply, to a power-supply-modulation amplifier, the "high-side switch configuration using a P channel MOSFET" illustrated in FIG. 5-19 in Non-Patent Literature 1.

In the high-side switch configuration illustrated in Non-Patent Literature 1, the source electrode of a P channel MOS is connected to V_{DD}, and the drain electrode of the P channel MOS is connected to one end of R_{L}.

A resistor R₄ is connected between V_{DD} and the gate electrode of the P channel MOS, a resistor R3 is connected between one end of the resistor R₄ and the collector electrode of a bipolar transistor, the emitter electrode of the bipolar transistor is grounded, and a pulse PG is input to the gate electrode of the bipolar transistor.

### CITATION LIST

### NON-PATENT LITERATURE

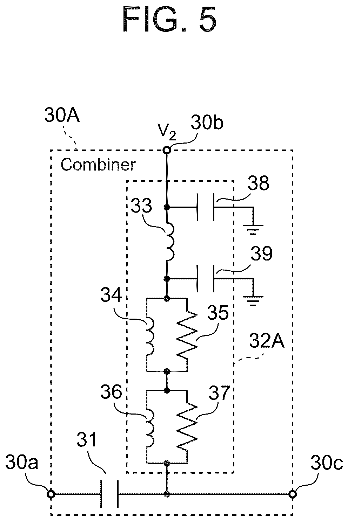

Non-Patent Literature 1: "Switching Power Supply [2] Mastering Elemental Technology" published on March 1, 2019, CO Publishing Co., Ltd., P194, P195, particularly FIG. 5-19

### SUMMARY OF INVENTION

### TECHNICAL PROBLEM

There is a problem with the high-side switch configuration illustrated in Non-Patent Literature 1 that because VGS is ensured by I_{C} flowing to the resistor R₄, current consumption increases, leading to lower overall efficiency of an integrated circuit in a case where a power-supply-modulation amplifier is integrated.

The present disclosure solves the problem described above, and an object thereof is to obtain a complementary power supply modulator that includes complementary switching elements connected in series between a power supply potential node and a ground potential node, and has a P-type transistor in a high-voltage-side switching element, the complementary power supply modulator reducing power consumption at the time when a bias voltage is applied to the gate electrode of the P-type transistor.

### SOLUTION TO PROBLEM

A complementary power supply modulator according to the present disclosure includes: a high-voltage-side switching element having: a first high-voltage-side main node connected to a first power supply potential node to which a first voltage is applied; a second high-voltage-side main node connected to an output terminal; and a high-voltage-side control node to which a PWM signal is input, the high-voltage-side switching element including a first P-type transistor having: a source electrode which is electrically connected to the first high-voltage-side main node; a drain electrode which is electrically connected to the second high-voltage-side main node; and a gate electrode which is electrically connected to the high-voltage-side control node; a low-voltage-side switching element having: a first low-voltage-side main node connected to the output terminal; a second low-voltage-side main node connected to a ground potential node; and a low-voltage-side control node to which a PWM signal is input, the low-voltage-side switching element including a first N-type transistor having: a drain electrode which is electrically connected to the first low-voltage-side main node; a source electrode which is electrically connected to the second low-voltage-side main node; and a gate electrode which is electrically connected to the low-voltage-side control node; and a high-voltage-side combiner having: a first high-voltage-side addition node electrically connected to an input terminal to which a PWM signal is input; a second high-voltage-side addition node electrically connected to a second power supply potential node to which a second voltage is applied; and a high-voltage-side combined output node that is electrically connected to the high-voltage-side control node of the high-voltage-side switching element, and outputs a PWM signal obtained by combining the PWM signal input to the first high-voltage-side addition node and the second voltage applied to the second high-voltage-side addition node.

### ADVANTAGEOUS EFFECTS OF INVENTION

According to the present disclosure, in a complementary power supply modulator having a P-type transistor in a high-voltage-side switching element, it is possible to reduce power consumption at the time when a bias voltage is applied to the gate electrode of the P-type transistor.

### BRIEF DESCRIPTION OF DRAWINGS

FIG. 1 is a configuration diagram illustrating a complementary power supply modulator according to a first embodiment.
FIG. 2 is a configuration diagram illustrating an example of a combiner in the complementary power supply modulator according to the first embodiment.
FIG. 3 is an equivalent circuit diagram illustrating a simulation of the combiner in the complementary power supply modulator according to the first embodiment.
FIG. 4 is a drawing illustrating simulation results of the combiner in the complementary power supply modulator according to the first embodiment.
FIG. 5 is a configuration diagram illustrating an example of a combiner in a complementary power supply modulator according to a second embodiment.
FIG. 6 is a configuration diagram illustrating a complementary power supply modulator according to a third embodiment.
FIG. 7 is a configuration diagram illustrating a complementary power supply modulator according to a fourth embodiment.
FIG. 8 is a configuration diagram illustrating a complementary power supply modulator according to a fifth embodiment.
FIG. 9 is a configuration diagram illustrating a complementary power supply modulator according to a sixth embodiment.

### DESCRIPTION OF EMBODIMENTS

### First Embodiment.

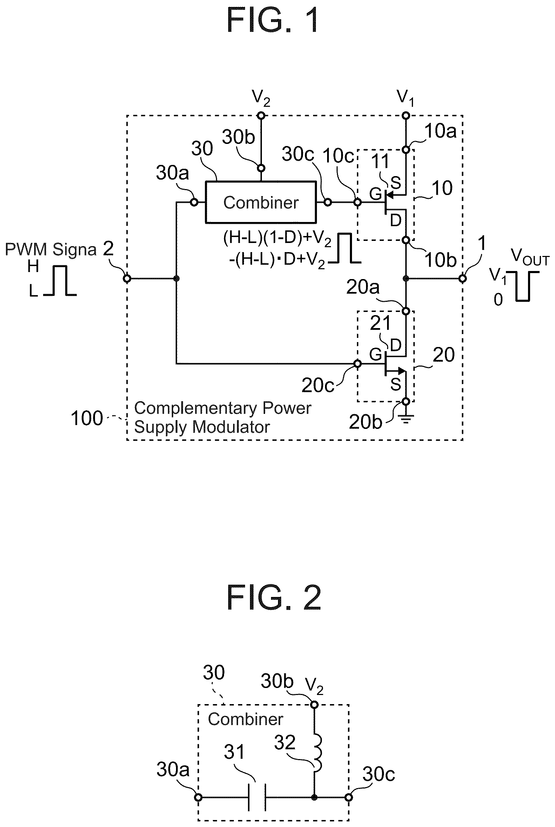

A complementary power supply modulator according to a first embodiment is explained using FIGS. 1 to 4.

A complementary power supply modulator 100 according to the first embodiment includes complementary switching elements connected in series between a first power supply potential node V₁ and a ground potential node, and having a connection point connected to an output node, has a P-type transistor 11 in a high-voltage-side switching element 10, and has an N-type transistor 21 in a low-voltage-side switching element 20.

A high-frequency PWM signal is input as an input signal to the complementary power supply modulator according to the first embodiment, and the amplitude of a voltage applied to the first power supply potential node V₁ is twice as large as or more than twice as large as the voltage amplitude of the PWM signal which is an input signal.

As illustrated in FIG. 1, the complementary power supply modulator according to the first embodiment includes the high-voltage-side switching element 10, the low-voltage-side switching element 20, and a high-voltage-side combiner 30.

The high-voltage-side switching element 10, the low-voltage-side switching element 20, and the high-voltage-side combiner 30 are incorporated as an integrated circuit.

The high-voltage-side switching element 10 has: a first high-voltage-side main node 10a connected to the first power supply potential node V₁ to which a first voltage V₁ is applied; a second high-voltage-side main node 10b connected to an output terminal 1; and a high-voltage-side control node 10c to which a PWM signal is input via the high-voltage-side combiner 30.

As an example, the first voltage V₁ applied to the first power supply potential node V₁ is 30 V.

As an example, the PWM signal has an H level which is 0 V, and an L level which is -3 V.

In this example, the voltage applied to the first power supply potential node V₁ has amplitude which is ten times as large as the voltage amplitude of the PWM signal which is an input signal.

The specific example illustrated here is an example, and this is not the sole example. In short, a complementary power supply modulator in which the amplitude of a voltage applied to the first power supply potential node V₁ is twice as large as or more than twice as large as the voltage amplitude of a PWM signal which is an input signal is the target modulator.

The first voltage V₁ applied to the first power supply potential node V₁ is supplied from a power supply circuit (not illustrated).

The high-voltage-side switching element 10 includes the first P-type transistor 11 having: a source electrode which is electrically directly connected to the first high-voltage-side main node 10a; a drain electrode which is electrically directly connected to the second high-voltage-side main node 10b; and a gate electrode which is electrically directly connected to the high-voltage-side control node 10c.

The first P-type transistor 11 is a P-type transistor (high-withstand-voltage transistor element) using a wide bandgap semiconductor.

The bandgap of the P-type transistor using the wide bandgap semiconductor is equal to or greater than 2.2 eV.

For example, as the first P-type transistor 11, a P-type Gallium Nitride (GaN) transistor or a diamond Metal Oxide Semiconductor Field Effect Transistor (MOSFET) is used, and, in particular, a P-type transistor using a wide bandgap semiconductor with bandgap which is equal to or greater than 3 eV is used.

Note that the specific example illustrated here as the first P-type transistor 11 is an example, and this is not the sole example. It is sufficient if the first P-type transistor 11 is a P-type transistor using a wide bandgap semiconductor, and may either be a normally-on transistor or a normally-off transistor.

The low-voltage-side switching element 20 has: a first low-voltage-side main node 20a connected to the output terminal 1; a second low-voltage-side main node 20b connected to the ground potential node; and a low-voltage-side control node 20c electrically directly connected to an input terminal 2 to which a PWM signal is input.

The low-voltage-side switching element 20 includes the first N-type transistor 21 having: a drain electrode which is electrically directly connected to the first low-voltage-side main node 20a; a source electrode which is electrically directly connected to the second low-voltage-side main node 20b; and a gate electrode which is electrically directly connected to the low-voltage-side control node 20c.

The first N-type transistor 21 is an N-type transistor (high-withstand-voltage transistor element) using a wide bandgap semiconductor.

The bandgap of the N-type transistor using the wide bandgap semiconductor is equal to or greater than 2.2 eV.

As the first N-type transistor 21, for example, an N-type GaN High Electron Mobility Transistor (HEMT: high electron mobility transistor) is used, and, in particular, an N-type transistor using a wide bandgap semiconductor with bandgap which is equal to or greater than 3 eV is used.

Note that the specific example illustrated here as the first N-type transistor 21 is an example, and this is not the sole example. It is sufficient if the first N-type transistor 21 is an N-type transistor using a wide bandgap semiconductor, and may either be a normally-on transistor or a normally-off transistor.

The high-voltage-side combiner 30 has: a first high-voltage-side addition node 30a electrically directly connected to the input terminal 2; a second high-voltage-side addition node 30b directly connected to a second power supply potential node V₂ to which a second voltage V₂ is applied; and a high-voltage-side combined output node 30c that is electrically directly connected to the high-voltage-side control node 10c of the high-voltage-side switching element 10, and outputs a PWM signal obtained by combining the PWM signal input to the first high-voltage-side addition node 30a and the second voltage V₂ applied to the second high-voltage-side addition node 30b.

As an example, the second voltage V₂ applied to the second power supply potential node V₂ is 31.5 V.

It is assumed now that the electric potential difference between the H level and L level of the PWM signal input to the input terminal 2 is (H-L), the duty ratio is D, and the second voltage V₂ applied to the second power supply potential node V₂ is V₂.

When the PWM signal is at the H level, a voltage that appears at the high-voltage-side combined output node 30c is the H level of (H-L)(1-D)+V₂, the first P-type transistor 11 gets turned off, the first N-type transistor 21 gets turned on, and a voltage that appears at the output terminal 1 is 0 V (ground potential).

When the PWM signal is at the L level, a voltage that appears at the high-voltage-side combined output node 30c is the L level of -(H-L)D+V₂, the first P-type transistor 11 gets turned on, the first N-type transistor 21 gets turned off, and a voltage that appears at the output terminal 1 is V₁ (the first voltage V₁ applied to the first power supply potential node Vi).

It is assumed as an example that the H level of the PWM signal is 0 V, the L level of the PWM signal is -3 V, the first voltage V₁ is 30 V, and the second voltage V₂ is 31.5 V.

When the PWM signal is at the H level, a voltage that appears at the high-voltage-side combined output node 30c is 33 V, and a voltage that appears at the output terminal 1 is 0 V.

When the PWM signal is at the L level, a voltage that appears at the high-voltage-side combined output node 30c is 30 V, and a voltage that appears at the output terminal 1 is 30 V.

Note that normally-on/depletion transistors are used as the first P-type transistor 11 and the first N-type transistor 21.

As illustrated in FIG. 2, the high-voltage-side combiner 30 has a DC block 31 which is a capacitor (condenser) and an inductor section 32 which is a choke coil. In the explanation of the first embodiment hereinbelow, the DC block 31 is referred to as a capacitor 31, and the inductor section 32 is referred to as a choke coil 32.

At the capacitor 31, one electrode is electrically directly connected to the first high-voltage-side addition node 30a, and the other electrode is electrically directly connected to the high-voltage-side combined output node 30c.

At the choke coil 32, one electrode is electrically directly connected to the second power supply potential node 30b, and the other electrode is electrically directly connected to the high-voltage-side combined output node 30c.

The constant of the capacitor 31 is determined in the following manner.

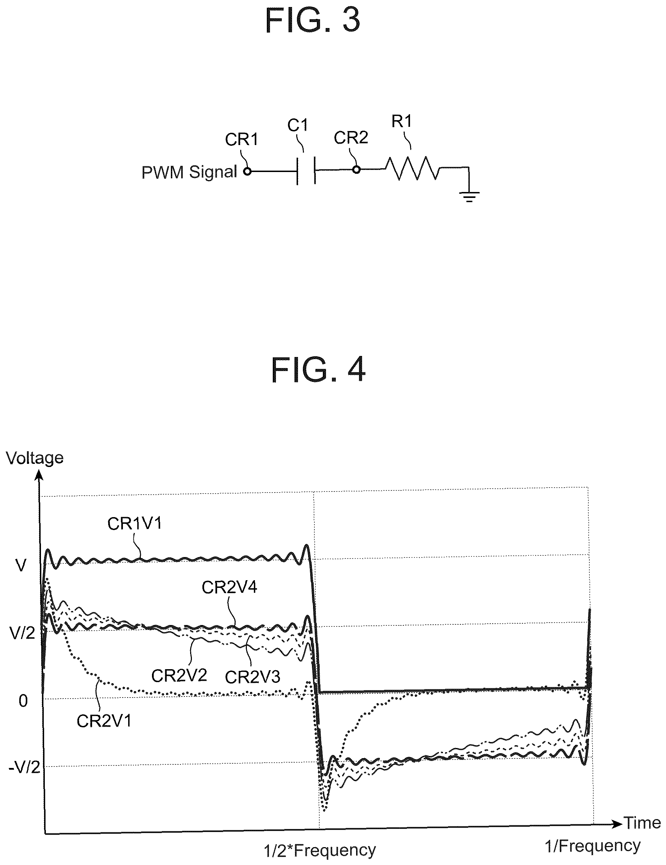

It is assumed now that there is an equivalent circuit illustrated in FIG. 3 in order to perform a simulation. Here, a simulation is performed using a series CR circuit in order to clarify the relationship with the time constant.

It is assumed that the equivalent circuit illustrated in FIG. 3 is a series circuit of a capacitor C1 and a resistor R1.

The capacitor C1 is connected between a terminal CR1 to which a PWM signal is input and a terminal CR2.

The capacitor C1 corresponds to the capacitor 31 in the high-voltage-side combiner 30.

The resistor R1 is connected between the terminal CR2 and a ground node.

The resistor R1 corresponds to a resistor with a resistance value determined by the choke coil 32 in the high-voltage-side combiner 30 and the input impedance of the first P-type transistor 11, and the like.

The simulation is performed assuming that the capacitance value of the capacitor C1 is 1 nF, and the resistance value of the resistor R1 is 50 Ω.

The value of the time constant calculated from the capacitor C1 and the resistor R1 is 5.0×10⁻⁸ seconds, and its reciprocal is 20 MHz.

It is assumed that the duty ratio of the PWM signal is 50%.

Results of the simulation performed under such conditions are illustrated in FIG. 4.

In FIG. 4, the horizontal axis represents time expressed by values normalized by the reciprocals of the frequencies of PWM signals, and the vertical axis represents voltage. A waveform CR1V1 represents the voltage amplitude of the PWM signal input to the terminal CR1, a waveform CR2V1 represents voltage amplitude at the terminal CR2 at the time when a PWM signal of 1 MHz is input, a waveform CR2V2 represents voltage amplitude at the terminal CR2 at the time when a PWM signal of 10 MHz is input, a waveform CR2V3 represents voltage amplitude at the terminal CR2 at the time when a PWM signal of 20 MHz is input, and a waveform CR2V4 represents voltage amplitude at the terminal CR2 at the time when a PWM signal of 100 MHz is input.

As can be understood from the simulation results in FIG. 4, while transient response characteristics can be recognized at the time of the PWM signal of 1 MHz (waveform CR2V1), the PWM signals do not return to the steady states fully as their frequencies increase (the waveform CR2V2 to the waveform CR2V4), and accordingly exhibit differential waveforms.

In simulation results (the waveform CR2V3) at the time when the PWM signal of 20 MHz, which is the reciprocal of the time constant, is input, zags of approximately V/5 are generated in relation to the voltage amplitude V (the waveform CR1V1) of the PWM signal.

However, by paying attention to the threshold voltage of the first P-type transistor 11, the capacitor can be applied as the capacitor 31 in the high-voltage-side combiner 30.

Accordingly, the capacitance value of the capacitor 31 in the high-voltage-side combiner 30 is determined in such a manner that the frequency of the PWM signal is equal to or greater than the reciprocal of the time constant.

In simulation results (the waveform CR2V4) at the time when the PWM signal of 100 MHz, which is five times as large as the reciprocal of the time constant, is input, zags are not generated almost at all.

Accordingly, in the case of use around the threshold voltage of the first P-type transistor 11, the capacitance value of the capacitor 31 in the high-voltage-side combiner 30 is suitably determined in such a manner that the frequency of the PWM signal is five times as large as or more than five times as large as the reciprocal of the time constant, preferably.

That is, it is sufficient if the capacitance value of the capacitor 31 that can control ON/OFF operation of the first P-type transistor 11 by an output waveform of the high-voltage-side combiner 30 is adjusted depending on the lower-limit frequency of the PWM signal and a resistance value, which corresponds to the resistor R1 and is determined by the choke coil 32 in the high-voltage-side combiner 30 and the input impedance of the first P-type transistor 11, or the like.

Note that the upper limit frequency of the PWM signal is determined by the cutoff frequency of the first P-type transistor 11.

In short, the capacitance value of the capacitor 31 is set to a value in such a manner that the frequency of the PWM signal is equal to or greater than the reciprocal of the time constant calculated from the capacitance value and the resistance value, the resistance value being obtained by the choke coil 32 and the input impedance of the first P-type transistor 11.

In particular, the capacitance value of the capacitor 31 is suitably set to a value in such a manner that the frequency of the PWM signal is five times as large as or more than five times as large as the reciprocal of the time constant calculated from the capacitance value and the resistance value, the resistance value being obtained by the choke coil 32 and the input impedance of the first P-type transistor 11.

The impedance of the choke coil 32 in the high-voltage-side combiner 30 is suitably made five times as large as or more than five times as large as the input impedance of the first P-type transistor 11 for the frequency of the PWM signal.

By making it five times or more than five times, the energy of the PWM signal can be sufficiently supplied to the gate electrode of the first P-type transistor 11.

As mentioned above, by configuring the high-voltage-side combiner 30 using the capacitor 31 and the choke coil 32, in particular by setting the capacitance value of the capacitor 31 to a value in such a manner that the frequency of the PWM signal is equal to or greater than the reciprocal of the time constant calculated from the capacitance value and the resistance value, the resistance value being obtained by the choke coil 32 and the input impedance of the first P-type transistor 11, and setting the impedance of the choke coil to a value which is five times as large as or more than five times as large as the input impedance of the first P-type transistor 11 for the frequency of the PWM signal, while power consumption at the time when a bias voltage is applied to the gate electrode of the first P-type transistor 11 is reduced, a PWM signal obtained by combining the PWM signal and the second voltage V₂ applied to the second high-voltage-side addition node 30b is applied as a bias voltage to the gate electrode of the first P-type transistor 11 included in the high-voltage-side switching element 10.

Next, operation performed by the complementary power supply modulator according to the first embodiment is explained.

When the H level of the PWM signal is input to the input terminal 2, at the high-voltage-side combiner 30, a voltage (H-L) which is the electric potential difference between the H level and L level of the PWM signal and the second voltage V₂ applied to the second power supply potential node V₂ are combined, and, at the high-voltage-side combined output node 30c, an H level of the combined voltage [(H-L)(1-D)+V₂] is applied to the gate electrode of the first P-type transistor 11 in the high-voltage-side switching element 10.

As a result, the first P-type transistor 11 gets turned off, and the first power supply potential node V₁ and the output terminal 1 get electrically cut off therebetween.

On the other hand, the voltage of the H level of the PWM signal is applied to the gate electrode of the first N-type transistor 21 included in the low-voltage-side switching element 20.

As a result, the first N-type transistor 21 gets turned on, and the output terminal 1 and the ground potential node become electrically conductive therebetween.

Therefore, the output terminal 1 is at the ground potential.

When the L level of the PWM signal is input to the input terminal 2, at the high-voltage-side combiner 30, a voltage -(H-L) which is the electric potential difference between the H level and L level of the PWM signal and the second voltage V₂ applied to the second power supply potential node V₂ are combined, and, at the high-voltage-side combined output node 30c, an L level of the combined voltage [-(H-L)D)+V₂] is applied to the gate electrode of the first P-type transistor 11 in the high-voltage-side switching element 10.

As a result, the first P-type transistor 11 gets turned on, and the first power supply potential node V₁ and the output terminal 1 become electrically conductive therebetween.

On the other hand, the voltage of the L level of the PWM signal is applied to the gate electrode of the first N-type transistor 21 included in the low-voltage-side switching element 20.

As a result, the first N-type transistor 21 gets turned off, and the output terminal 1 and the ground potential node get electrically cut off therebetween.

Therefore, the output terminal 1 is set to the first voltage V₁ applied to the first power supply potential node V₁.

As mentioned above, the complementary power supply modulator according to the first embodiment includes the high-voltage-side switching element 10 and the low-voltage-side switching element 20 that are connected in series between the first power supply potential node V₁ and the ground potential node, the high-voltage-side switching element 10 includes the first P-type transistor 11, the low-voltage-side switching element 20 includes the first N-type transistor 21, and the complementary power supply modulator includes the high-voltage-side combiner 30 that applies, to the gate electrode of the first P-type transistor 11, a PWM signal obtained by combining a PWM signal and the second voltage V₂ applied to the second power supply potential node V₂. Accordingly, while power consumption at the time when a bias voltage is applied to the gate electrode of the first P-type transistor 11 is reduced, ON/OFF operation of the first P-type transistor 11 included in the high-voltage-side switching element 10 can be controlled.

That is, since there is no resistive loss at the time when the high-voltage-side combiner 30 combines the second voltage and the PWM signal in order to generate a bias voltage with a high voltage value at the gate electrode of the first P-type transistor 11, power consumption can be reduced.

In addition, since power consumption can be reduced, in a case where the high-voltage-side switching element 10, the low-voltage-side switching element 20, and the high-voltage-side combiner 30 are incorporated as an integrated circuit, the efficiency of the integrated circuit can be enhanced.

### Second Embodiment.

A complementary power supply modulator according to a second embodiment is explained using FIG. 5.

The complementary power supply modulator according to the second embodiment is obtained simply by making a change to the high-voltage-side combiner 30 in the complementary power supply modulator according to the first embodiment, and is the same as the complementary power supply modulator according to the first embodiment in other respects.

Reference signs in FIG. 5 that are identical to the reference signs illustrated in FIGS. 1 and 2 represent identical or equivalent portions.

Similarly to the complementary power supply modulator according to the first embodiment, the complementary power supply modulator according to the second embodiment includes a high-voltage-side switching element 10, a low-voltage-side switching element 20, and a high-voltage-side combiner 30A.

Since the high-voltage-side switching element 10 and the low-voltage-side switching element 20 are the same as the high-voltage-side switching element 10 and the low-voltage-side switching element 20 in the complementary power supply modulator according to the first embodiment, explanation thereof is omitted.

As illustrated in FIG. 5, the high-voltage-side combiner 30A has a DC block 31 which is a capacitor (condenser) and an inductor section 32A.

A capacitor which is the DC block 31 is the same as the capacitor 31 in the first embodiment, and the manner of setting a capacitance value also is the same as the manner of setting a capacitance value explained in the first embodiment.

The inductor section 32A has: a first inductor 33; a first parallel body including a second inductor 34 and a first resistor 35; a second parallel body including a third inductor 36 and a second resistor 37; a first capacitor 38; and a second capacitor 39.

The first inductor 33, the first parallel body including the second inductor 34 and the first resistor 35, and the second parallel body including the third inductor 36 and the second resistor 37 are connected in series in order between a second power supply potential node 30b and a high-voltage-side combined output node 30c.

The first capacitor 38 is connected between a ground node and one electrode of the first inductor 33 on a side where the first inductor 33 is electrically connected with a second power supply potential node V₂.

The second capacitor 39 is connected between a ground node and a connection point between the other electrode of the first inductor 33 and one end of the first parallel body including the second inductor 34 and the first resistor 35.

By setting inductance values and capacitance values which are circuit constants of the first parallel body, the second parallel body, the first capacitor 38, and the second capacitor 39, it is possible to achieve stabilization for a plurality of frequencies of PWM signals.

The impedance of the inductor section 32A between the second power supply potential node V₂ and the high-voltage-side combined output node 30c is suitably made five times as large as or more than five times as large as the input impedance of a first P-type transistor 11 for a frequency of a PWM signal.

Circuit constants of elements included in the inductor section 32A are set in such a manner that a second voltage V₂ applied to the second power supply potential node V₂ does not drop due to the inductor section 32A.

The complementary power supply modulator according to the second embodiment achieves advantageous effects similar to those of the complementary power supply modulator according to the first embodiment.

### Third Embodiment.

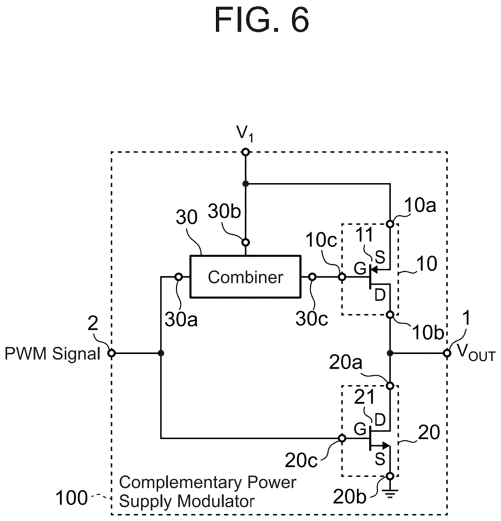

A complementary power supply modulator according to a third embodiment is explained using FIG. 6.

The complementary power supply modulator according to the third embodiment is different from the complementary power supply modulator according to the first embodiment in that a second voltage V₂ applied to a second high-voltage-side addition node 30b of a high-voltage-side combiner 30 is the same voltage as a first voltage V₁ while the second voltage V₂ is higher than the first voltage V₁ in the complementary power supply modulator according to the first embodiment, and the complementary power supply modulator according to the third embodiment is the same as the complementary power supply modulator according to the first embodiment in other respects.

Reference signs in FIG. 6 that are identical to the reference signs illustrated in FIGS. 1 and 2 represent identical or equivalent portions.

Hereinbelow, differences from the first embodiment are explained mainly.

The second high-voltage-side addition node 30b in the high-voltage-side combiner 30 is directly connected to a first power supply potential node V₁ to which the first voltage V₁ is applied.

Accordingly, the second voltage V₂ applied to the second high-voltage-side addition node 30b in the high-voltage-side combiner 30 is the same as the first voltage V₁.

As a result, a PWM signal obtained by combining a PWM signal input to a first high-voltage-side addition node 30a and the first voltage V₁ applied to the second high-voltage-side addition node 30b is output to a high-voltage-side combined output node 30c in the high-voltage-side combiner 30.

In the complementary power supply modulator according to the third embodiment, a normally-off/enhancement P-type transistor is suitably used as a first P-type transistor 11 included in a high-voltage-side switching element 10.

In a case where a normally-on/depletion P-type transistor is used as the first P-type transistor 11, the threshold voltage of the first P-type transistor 11 and the voltage amplitude and duty ratio of a PWM signal are set in such a manner that control of ON/OFF operation of the first P-type transistor 11 becomes possible.

The complementary power supply modulator according to the third embodiment achieves advantageous effects similar to those of the complementary power supply modulator according to the first embodiment.

Note that, in the complementary power supply modulator according to the third embodiment, the high-voltage-side combiner 30A illustrated in the complementary power supply modulator according to the second embodiment may be used as the high-voltage-side combiner 30.

### Fourth Embodiment.

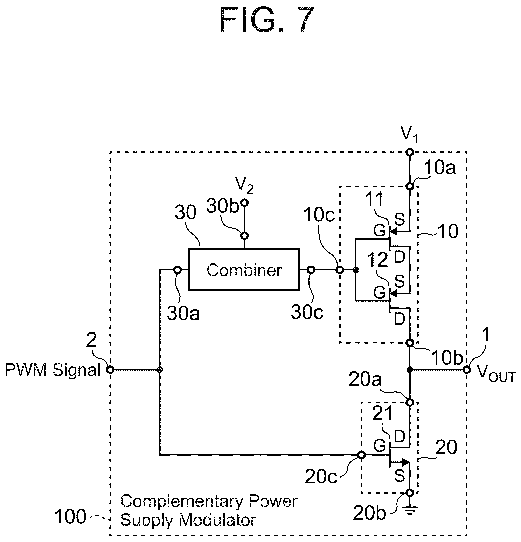

A complementary power supply modulator according to a fourth embodiment is explained using FIG. 7.

The complementary power supply modulator according to the fourth embodiment is different from the complementary power supply modulator according to the first embodiment in that a second P-type transistor 12 cascode-connected with the first P-type transistor 11 is added to the high-voltage-side switching element 10 while the high-voltage-side switching element 10 includes the first P-type transistor 11 in the complementary power supply modulator according to the first embodiment, and the complementary power supply modulator according to the fourth embodiment is the same as the complementary power supply modulator according to the first embodiment in other respects.

Reference signs in FIG. 7 that are identical to the reference signs illustrated in FIGS. 1 and 2 represent identical or equivalent portions.

Hereinbelow, the high-voltage-side switching element 10, which is the difference from the first embodiment, is explained mainly.

The high-voltage-side switching element 10 includes the cascode-connected first P-type transistor 11 and second P-type transistor 12.

The first P-type transistor 11 has: a source electrode which is electrically directly connected to the first high-voltage-side main node 10a; a drain electrode which is indirectly electrically connected to a second high-voltage-side main node 10b via the second P-type transistor 12; and a gate electrode which is electrically directly connected to a high-voltage-side control node 10c.

The second P-type transistor 12 has: a source electrode which is electrically directly connected to the drain electrode of the first P-type transistor 11; a drain electrode which is electrically directly connected to the second high-voltage-side main node 10b; and a gate electrode which is electrically directly connected to the high-voltage-side control node 10c.

Similarly to the first P-type transistor 11, the second P-type transistor 12 is a P-type transistor (high-withstand-voltage transistor element) using a wide bandgap semiconductor, and, for example, is a P-type GaN transistor or a diamond MOSFET.

A combined voltage from a high-voltage-side combined output node 30c in a high-voltage-side combiner 30 is input to the gate electrode of the first P-type transistor 11 and the gate electrode of the second P-type transistor 12, and ON/OFF operation of the first P-type transistor 11 and the second P-type transistor 12 is simultaneously controlled.

Since the high-voltage-side switching element 10 includes the cascode-connected first P-type transistor 11 and second P-type transistor 12 in this manner, a source-drain voltage applied to each of the first P-type transistor 11 and the second P-type transistor 12 can be distributed, and a first voltage V₁ exceeding the withstand voltage of each of the first P-type transistor 11 and the second P-type transistor 12 can be applied thereto.

There is a trade-off between the on-resistance and the cutoff frequency and the withstand voltage of a transistor typically, but, by lowering the withstand voltage of each of the first P-type transistor 11 and the second P-type transistor 12, the on-resistance can be reduced, and the cutoff frequency can be increased.

The complementary power supply modulator according to the fourth embodiment achieves advantageous effects similar to those of the complementary power supply modulator according to the first embodiment. In addition, the on-resistance in the high-voltage-side switching element 10 can be reduced, and the cutoff frequency in the high-voltage-side switching element 10 can be increased.

Note that the number of stages of cascode-connected transistors in the high-voltage-side switching element 10 is not limited to the two stages, the first P-type transistor 11 and the second P-type transistor 12, but three or more stages of P-type transistors may be cascode-connected.

In addition, in the complementary power supply modulator according to the fourth embodiment, the high-voltage-side combiner 30A illustrated in the complementary power supply modulator according to the second embodiment may be used as the high-voltage-side combiner 30.

Furthermore, similarly to the complementary power supply modulator according to the third embodiment, in the complementary power supply modulator according to the fourth embodiment, a second voltage V₂ applied to a second high-voltage-side addition node 30b of the high-voltage-side combiner 30 may be made the same voltage as the first voltage V₁.

### Fifth Embodiment.

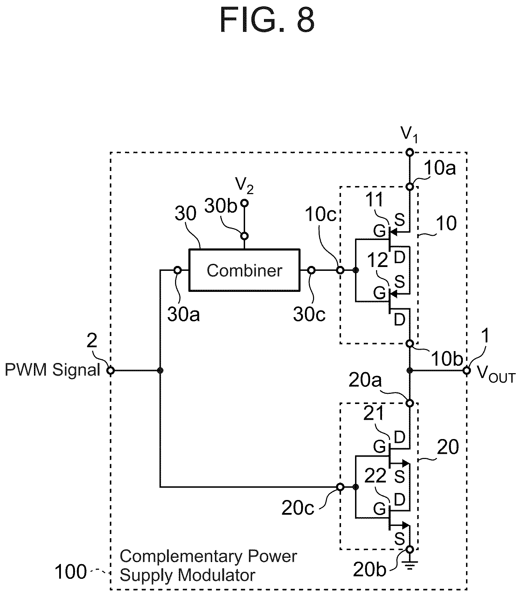

A complementary power supply modulator according to a fifth embodiment is explained using FIG. 8.

The complementary power supply modulator according to the fifth embodiment is different from the complementary power supply modulator according to the fourth embodiment in that a second N-type transistor 22 cascode-connected with the first N-type transistor 21 is added to the low-voltage-side switching element 20 while the low-voltage-side switching element 20 includes the first N-type transistor 21 in the complementary power supply modulator according to the fourth embodiment, and the complementary power supply modulator according to the fifth embodiment is the same as the complementary power supply modulator according to the fourth embodiment in other respects.

Reference signs in FIG. 8 that are identical to the reference signs illustrated in FIGS. 1, 2, and 7 represent identical or equivalent portions.

Hereinbelow, the low-voltage-side switching element 20, which is the difference from the fourth embodiment, is explained mainly.

The low-voltage-side switching element 20 includes the cascode-connected first N-type transistor 21 and second N-type transistor 22.

The first N-type transistor 21 has: a drain electrode which is electrically directly connected to a first low-voltage-side main node 20a; a source electrode which is directly electrically connected indirectly to a second low-voltage-side main node 20b via the second N-type transistor 22; and a gate electrode which is electrically directly connected to a low-voltage-side control node 20c.

The second N-type transistor 22 has: a drain electrode which is electrically directly connected to the source electrode of the first N-type transistor 21; a source electrode which is electrically directly connected to the second low-voltage-side main node 20b; and a gate electrode which is directly connected to the low-voltage-side control node.

Similarly to the first N-type transistor 21, the second N-type transistor 22 is an N-type transistor (high-withstand-voltage transistor element) using a wide bandgap semiconductor, and, for example, is an N-type GaN HEMT.

A PWM signal is input to the gate electrode of the first N-type transistor 21 and the gate electrode of the second N-type transistor 22, and ON/OFF operation of the first N-type transistor 21 and the second N-type transistor 22 is simultaneously controlled.

Since the low-voltage-side switching element 20 includes the cascode-connected first N-type transistor 21 and second N-type transistor 22 in this manner, a source-drain voltage applied to each of the first N-type transistor 21 and the second N-type transistor 22 can be distributed, and a first voltage V₁ exceeding the withstand voltage of each of the first N-type transistor 21 and the second N-type transistor 22 can be applied thereto.

The complementary power supply modulator according to the fifth embodiment achieves advantageous effects similar to those of the complementary power supply modulator according to the fourth embodiment.

Note that the number of stages of cascode-connected transistors in the low-voltage-side switching element 20 is not limited to the two stages, the first N-type transistor 21 and the second N-type transistor 22, but three or more stages of N-type transistors may be cascode-connected.

In addition, in the complementary power supply modulator according to the fifth embodiment, the high-voltage-side combiner 30A illustrated in the complementary power supply modulator according to the second embodiment may be used as a high-voltage-side combiner 30.

Furthermore, similarly to the complementary power supply modulator according to the third embodiment, in the complementary power supply modulator according to the fifth embodiment, a second voltage V₂ applied to a second high-voltage-side addition node 30b of the high-voltage-side combiner 30 may be made the same voltage as the first voltage V₁.

### Sixth Embodiment.

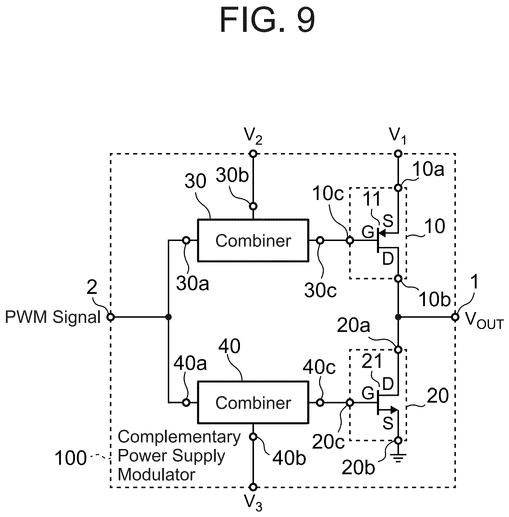

A complementary power supply modulator according to a sixth embodiment is explained using FIG. 9.

The complementary power supply modulator according to the second embodiment is obtained simply by adding the low-voltage-side combiner 40 to the complementary power supply modulator according to the first embodiment, and is the same as the complementary power supply modulator according to the first embodiment in other respects.

Reference signs in FIG. 9 that are identical to the reference signs illustrated in FIGS. 1 and 2 represent identical or equivalent portions.

Hereinbelow, the low-voltage-side combiner 40, which is the difference from the first embodiment, is explained mainly.

The low-voltage-side combiner 40 has: a first low-voltage-side addition node 40a electrically directly connected to an input terminal 2; a second low-voltage-side addition node 40b directly connected to a third power supply potential node V₃ to which a third voltage V₃ is applied; and a low-voltage-side combined output node 40c that is connected to a low-voltage-side control node 20c of a low-voltage-side switching element 20, and outputs a PWM signal obtained by combining a PWM signal input to the first low-voltage-side addition node 40a and the third voltage V₃ applied to the second low-voltage-side addition node 40b.

A normally-on/depletion N-type transistor is used as a first N-type transistor 21 included in the low-voltage-side switching element 20, and the third voltage V₃ applied to the second low-voltage-side addition node 40b is set to a negative voltage.

In this way, a negative value does not have to be added to a PMW signal.

Note that a second voltage V₂ applied to a second power supply potential node V₂ is preferably made the same as a first voltage V₁ applied to a first power supply potential node V₁.

Similarly to the high-voltage-side combiner 30 in the first embodiment illustrated in FIG. 2, the low-voltage-side combiner 40 has a DC block which is a capacitor (condenser) and an inductor section which is a choke coil.

At the capacitor in the low-voltage-side combiner 40, one electrode is electrically directly connected to the first low-voltage-side addition node 40a, and the other electrode is electrically directly connected to the low-voltage-side combined output node 40c.

At the choke coil in the low-voltage-side combiner 40, one electrode is electrically directly connected to the third power supply potential node V₃, and the other electrode is electrically directly connected to the low-voltage-side combined output node 40c.

In addition, similarly to the high-voltage-side combiner 30A in the second embodiment illustrated in FIG. 5, the low-voltage-side combiner 40 may have a DC block which is a capacitor (condenser) and an inductor section.

In this case, at the capacitor in the low-voltage-side combiner 40, one electrode is electrically directly connected to the first low-voltage-side addition node 40a, and the other electrode is electrically directly connected to the low-voltage-side combined output node 40c.

At the inductor section in the low-voltage-side combiner 40, the first inductor, the first parallel body including the second inductor and the first resistor, and the second parallel body including the third inductor and the second resistor are connected in series in order from the third power supply potential node V₃ to the low-voltage-side combined output node 40c, the first capacitor is connected between one electrode of the first inductor and a ground node, and the second capacitor is connected between a ground node and a connection point between the other electrode of the first inductor and one end of the first parallel body.

Note that the low-voltage-side combiner 40 may be changed only to a capacitor included in a DC block by settings of the threshold voltage of the first N-type transistor 21, and the voltage amplitude and duty ratio of a PWM signal.

In the complementary power supply modulator according to the sixth embodiment, assuming that, for example, the H level of a PWM signal is 3 V, the L level of the PWM signal is 0 V, and the third voltage V₃ is -3 V, when the PWM signal is at the H level, a combined voltage 0 V is output to the low-voltage-side combined output node 40c in the low-voltage-side combiner 40, and the first N-type transistor 21 included in the low-voltage-side switching element 20 gets turned on, and when the PWM signal is at the L level, a combined voltage -3 V is output to the low-voltage-side combined output node 40c in the low-voltage-side combiner 40, and the first N-type transistor 21 included in the low-voltage-side switching element 20 gets turned off when the PWM signal is at the L level.

The complementary power supply modulator according to the sixth embodiment achieves advantageous effects similar to those of the complementary power supply modulator according to the first embodiment.

Note that, similarly to the complementary power supply modulator according to the fourth embodiment, a second P-type transistor 12 cascode-connected with a first P-type transistor 11 may be added to a high-voltage-side switching element 10 in the complementary power supply modulator according to the sixth embodiment.

In addition, similarly to the complementary power supply modulator according to the fifth embodiment, in the complementary power supply modulator according to the sixth embodiment, the second P-type transistor 12 cascode-connected with the first P-type transistor 11 may be added to the high-voltage-side switching element 10, and a second N-type transistor 22 cascode-connected with the first N-type transistor 21 may be added to the low-voltage-side switching element 20.

Note that the present disclosure allows any combinations of each of the embodiments, modifications of any constituent elements in each of the embodiments, and omissions of any constituent elements in each of the embodiments.

### INDUSTRIAL APPLICABILITY

The complementary power supply modulator according to the present disclosure is preferable as a power supply modulator that modulates an applied bias voltage depending on the voltage level of an input signal which is a PWM signal.

In addition, the complementary power supply modulator according to the present disclosure is suited for a power supply modulator used for a power-supply-modulation amplifier.

### REFERENCE SIGNS LIST

1: Input terminal; 2: Output terminal; 10: High-voltage-side switching element; 10a: First high-voltage-side main node; 10b: Second high-voltage-side main node; 10c: High-voltage-side control node; 11: First P-type transistor; 20: Low-voltage-side switching element; 20a: First low-voltage-side main node; 20b: Second low-voltage-side main node; 20c: Low-voltage-side control node; 21: First N-type transistor; 30: High-voltage-side combiner; 30a: First high-voltage-side addition node; 30b: Second high-voltage-side addition node; 30c: High-voltage-side combined output node; 31: Capacitor; 32: Choke coil; 40: Low-voltage-side combiner

## Claims

1. A complementary power supply modulator comprising:
a high-voltage-side switching element having: a high-voltage-side control node to which a PWM signal is input; a first high-voltage-side main node connected to a first power supply potential node to which a first voltage having amplitude which is twice as large as or more than twice as large as amplitude of the PWM signal is applied; and a second high-voltage-side main node connected to an output terminal, the high-voltage-side switching element including a first P-type transistor having: a source electrode which is electrically connected to the first high-voltage-side main node; a drain electrode which is electrically connected to the second high-voltage-side main node; and a gate electrode which is electrically connected to the high-voltage-side control node;
a low-voltage-side switching element having: a first low-voltage-side main node connected to the output terminal; a second low-voltage-side main node connected to a ground potential node; and a low-voltage-side control node to which a PWM signal is input, the low-voltage-side switching element including a first N-type transistor having: a drain electrode which is electrically connected to the first low-voltage-side main node; a source electrode which is electrically connected to the second low-voltage-side main node; and a gate electrode which is electrically connected to the low-voltage-side control node; and
a high-voltage-side combiner having: a first high-voltage-side addition node electrically connected to an input terminal to which a PWM signal is input; a second high-voltage-side addition node electrically connected to a second power supply potential node to which a second voltage is applied; and a high-voltage-side combined output node that is electrically connected to the high-voltage-side control node of the high-voltage-side switching element, and outputs a PWM signal obtained by combining the PWM signal input to the first high-voltage-side addition node and the second voltage applied to the second high-voltage-side addition node, the high-voltage-side combiner not incurring resistive loss for combining the PWM signal input to the first high-voltage-side addition node and the second voltage applied to the second high-voltage-side addition node.

2. The complementary power supply modulator according to claim 1, wherein the first P-type transistor is a transistor using a wide bandgap semiconductor having a bandgap which is equal to or greater than 3 eV, and the first N-type transistor is a transistor using a wide bandgap semiconductor having a bandgap which is equal to or greater than 3 eV.

3. The complementary power supply modulator according to claim 1, wherein the high-voltage-side combiner has: a DC block electrically connected between the first high-voltage-side addition node and the high-voltage-side combined output node; and a choke coil electrically connected between the second high-voltage-side addition node and the high-voltage-side combined output node.

4. The complementary power supply modulator according to claim 3, wherein
the DC block is a capacitor, and
a capacitance value of the capacitor is set to a value in such a manner that a frequency of the PWM signal is equal to or greater than a reciprocal of a time constant calculated from input impedance of the first P-type transistor and a resistance value of the choke coil.

5. The complementary power supply modulator according to claim 3, wherein
the DC block is a capacitor, and
a capacitance value of the capacitor is set to a value in such a manner that a frequency of the PWM signal is five times as large as or more than five times as large as a reciprocal of a time constant calculated from input impedance of the first P-type transistor and a resistance value of the choke coil.

6. The complementary power supply modulator according to claim 3, wherein impedance of the choke coil is set to a value which is five times as large as or more than five times as large as input impedance of the first P-type transistor for a frequency of the PWM signal.

7. The complementary power supply modulator according to claim 1, wherein the second voltage applied to the second power supply potential node is a voltage which is higher than the first voltage applied to the first power supply potential node.

8. The complementary power supply modulator according to claim 1, wherein the second voltage applied to the second power supply potential node is the same voltage as the first voltage applied to the first power supply potential node.

9. The complementary power supply modulator according to claim 1, wherein the high-voltage-side combiner has:
a DC block including a capacitor electrically connected between the first high-voltage-side addition node and the high-voltage-side combined output node; and
an inductor section including: a first inductor, a first parallel body including a second inductor and a first resistor, and a second parallel body including a third inductor and a second resistor, the first inductor, the first parallel body, and the second parallel body being connected in series in order between the second high-voltage-side addition node and the high-voltage-side combined output node; a first capacitor connected between the second high-voltage-side addition node and a ground node; and a second capacitor connected between a ground node and a connection point between the first inductor and the first parallel body.

10. The complementary power supply modulator according to any one of claims 1 to 9, further comprising a low-voltage-side combiner having: a first low-voltage-side addition node electrically connected to the input terminal; a second low-voltage-side addition node connected to a third power supply potential node to which a third voltage is applied; and a low-voltage-side combined output node that is connected to the low-voltage-side control node of the low-voltage-side switching element, and outputs a PWM signal obtained by combining the PWM signal input to the first low-voltage-side addition node and a third voltage applied to the second low-voltage-side addition node.

11. The complementary power supply modulator according to any one of claims 1 to 9, wherein the high-voltage-side switching element further includes a P-type transistor that is cascode-connected with the first P-type transistor at two or more stages.

12. The complementary power supply modulator according to any one of claims 1 to 9, wherein the low-voltage-side switching element further includes an N-type transistor that is cascode-connected with the first N-type transistor at two or more stages.
